# EUROPÄISCHE PATENTANMELDUNG

(11) **EP 2 390 904 A2**
(43) Veröffentlichungstag der Anmeldung: **30.11.2011**
(21) Anmeldenummer: 11162103.3
(22) Anmeldetag: 12.04.2011
(51) Int. Cl.: H01L 21/60

(54) **Verfahren zur Niedertemperatur Drucksinterverbindung zweier Verbindungspartner und hiermit hergestellte Anordnung**

(30) Priorität: 27.05.2010 DE 102010021764
(71) Anmelder: SEMIKRON Elektronik GmbH & Co. KG, 90431 Nürnberg (DE)
(72) Erfinder: Augustin, Karlheinz, 90768, Fürth (DE); Göbl, Christian, 90441, Nürnberg (DE); Faltenbacher, Josef, 91052, Erlangen (DE); Sagebaum, Ulrich, 90537, Feucht (DE); Dr. Stockmeier, Thomas, 91054, Erlangen (DE)

(57) **Zusammenfassung**

Die Anmeldung betrifft eine Anordnung und ein Verfahren zu deren Herstellung. Diese weist einen ersten und einem zweiten Verbindungspartner auf, die mittels einer Niedertemperatur-Drucksinterverbindung miteinander stoffschlüssig mittels einer Sintermetallschicht verbunden sind. Die Verfahrensschritte sind: Bereitstellen eines ersten Verbindungspartners mit einer ersten Kontaktfläche. Aufbringen einer Schicht aus einer Sinterpaste, bestehend aus Sintermetallpartikeln und einem Lösungsmittel, auf die erste Kontaktfläche. Temperaturbeaufschlagung der Sinterpaste und Austreiben des Lösungsmittels unter Bildung der Sinterschicht. Aufbringen einer Flüssigkeit auf der Sinterschicht. Anordnen des zweiten Verbindungspartners. Anordnen eines Adhäsionsmittels im Randbereich der Sinterschicht und des zweiten Verbindungspartners mit Kontakt zum ersten Verbindungspartner zur Fixierung der Verbindungspartner zueinander. Weitere Beaufschlagung der Anordnung mit Temperatur und Druck zur Ausbildung der stoffschlüssigen Niedertemperatur-Drucksinterverbindung zwischen den Verbindungspartnern, wobei die Sinterschicht zur homogenen Sintermetallschicht umgewandelt wird.

## Beschreibung

Die Erfindung beschreibt ein Herstellungsverfahren zur Niedertemperatur-Drucksinterverbindung zweier Verbindungspartner mit jeweils zu verbindenden Kontaktflächen sowie eine mittels dieses Verfahrens hergestellte Anordnung.

Derartige Anordnungen sind beispielhaft auf dem Gebiet der leistungselektronischen Schaltungen hinlänglich bekannt. Dort werden beispielhaft Leistungshalbleiterbauelemente stoffschlüssig mit Substraten verbunden und in Leistungshalbleitermodulen angeordnet.

Beispielhaft beschreibt die DE 10 2005 058 794 A1 eine Vorrichtung für ein getaktetes Verfahren zur Ausbildung einer derartigen Verbindung wobei die Pressvorrichtung für den getakteten Betrieb einen Pressstempel und einen beheizbaren Presstisch aufweist und wobei ein druckstabiles Transportband direkt oberhalb des Presstischs verlaufend angeordnet ist. Zusätzlich ist zwischen dem Substrat mit den hierauf angeordneten Bauelementen und dem Pressstempel eine Schutzfolie vorgesehen.

Die bekannten Verfahren weisen allerdings den Nachteil auf, dass das Lösungsmittel erst nach dem Anordnen der Verbindungspartner in der Vorrichtung zur Niedertemperatur- Drucksinterverbindung die Temperaturbeaufschlagung erfolgt und es somit bei der Ausbildung der Verbindung zu Lunkern kommt. Derartige Lunker sind Gaseinschlüsse in der Sintermetallschicht mit einem Durchmesser von mindestens 30µm.

Der Erfindung liegt die Aufgabe zugrunde ein Herstellungsverfahren und eine hierdurch auszubildende Anordnung mit einer stoffschlüssigen Verbindung in Form einer Niedertemperatur-Drucksinterverbindung zweier Verbindungspartner vorzustellen, wobei die Bildung von Lunkern in der Sintermetallschicht der Niedertemperatur-Drucksinterverbindung verhindert oder zumindest deren Größe wesentlich reduziert wird.

Die Aufgabe wird erfindungsgemäß gelöst, durch ein Verfahren mit den Merkmalen des Anspruchs 1, sowie durch eine Anordnung gemäß Anspruch 7. Bevorzugte Ausführungsformen sind in den jeweiligen abhängigen Ansprüchen beschrieben.

Mittels des erfindungsgemäßen Verfahrens wird eine Anordnung mit einem ersten und einem zweiten Verbindungspartner hergestellt, wobei diese Verbindungspartner mittels einer Niedertemperatur-Drucksinterverbindung stoffschlüssig miteinander verbunden sind. Hierbei weist jeder der Verbindungspartner jeweils eine mit dem anderen Verbindungspartner zu verbindenden Kontaktfläche auf, wobei zwischen diesen Kontaktflächen eine Sintermetallschicht angeordnet ist. Dieses Verfahren umfasst die im Folgenden genannten Schritte. Im Rahmen des erfindungsgemäßen Verfahrens werden die Schritte d) und f) vorteilhafterweise in der genannten Reihenfolge ausgeführt. Es kann allerdings auch bevorzugt sein nur einen der beiden Schritte d) oder f) alternativ auszuführen.
a) Bereitstellen eines ersten Verbindungspartners mit einer ersten Kontaktfläche, wobei diese vorzugsweise eine Edelmetalloberfläche aufweist. Im Folgenden ist es vorteilhaft, diese Kontaktfläche mittels Einwirkung von Ultraschall von vorhandenen Verunreinigungen zu befreien. Die Einwirkung von Ultraschall kann vor dem nächsten Verfahrensschritt beendet werden, allerdings ist es besonders vorteilhaft um neuerliche Verunreinigungen zu verhindern diese Einwirkung mit dem nächsten Verarbeitungsschritt zeitlich überlappen zu lassen.
b) Aufbringen einer Schicht aus einer Sinterpaste, bestehend aus Sintermetallpartikeln, vorzugsweise Silberpartikeln, und einem Lösungsmittel, auf die erste Kontaktfläche.
c) Temperaturbeaufschlagung der Sinterpaste und hierdurch Austreiben des Lösungsmittels unter Bildung der Sinterschicht, die aus noch nicht miteinander verbundenen Sintermetallpartikeln besteht.
d) Aufbringen einer Flüssigkeit auf der Sinterschicht, wobei diese Flüssigkeit vorzugsweise eine polare Flüssigkeit, wie beispielhaft Glycerin ist. Diese Flüssigkeit dient im nachfolgenden Schritt der Fixierung des zweiten Verbindungspartners auf der Sinterschicht, die nach dem Austreiben des Lösungsmittels nur geringe adhäsive Kräfte zu Fixierung des zweiten Verbindungspartners aufweist.
e) Anordnen des zweiten Verbindungspartners derart, dass dessen zweite Kontaktfläche auf der Schicht aus Sinterpaste, respektive bei Vorhandensein der Flüssigkeit gemäß Schritt d) präzise ausgedrückt auf dieser, zu liegen kommt.
f) Anordnen eines Adhäsionsmittels im Randbereich der Sinterschicht und des zweiten Verbindungspartners mit Kontakt des Adhäsionsmittels zum ersten Verbindungspartner zur Fixierung der Verbindungspartner zueinander. Hierbei kann es ausreichend sein das Adhäsionsmittel, das vorzugsweise ein Silikon ist, nur an mindestens zwei einzelnen Stellen der Anordnung aufzubringen. Besonders vorteilhaft ist es allerdings den gesamten beschriebenen Bereich umlaufend mit diesem Adhäsionsmittel zu versehen.
g) Weitere Beaufschlagung der Anordnung mit Temperatur und Druck zur Ausbildung der stoffschlüssigen Niedertemperatur-Drucksinterverbindung zwischen den Verbindungspartnern. Hierbei wird die Flüssigkeit, die gemäß Schritt d) zwischen der Sinterschicht und dem zweiten Verbindungspartner angeordnet sein kann, ausgetrieben und die Sinterschicht zur homogenen Sintermetallschicht umgewandelt. Unter homogener Sintermetallschicht wird hier eine Metallschicht mit Lunkern verstanden deren maximaler Durchmesser 10µm beträgt.

Mittels des beschriebenen erfindungsgemäßen Verfahrens entsteht somit eine Anordnung zweier Verbindungspartner mit einer deren Kontaktflächen verbindenden Sintermetallschicht. Diese Sintermetallschicht ist erfindungsgemäß als homogene Schicht ausgebildet ist weist ausschließlich Lunker mit einem Durchmesser von maximal 10 µm auf.

Der wesentliche Vorteil des erfindungsgemäßen Verfahren bzw. der hierdurch hergestellten erfindungsgemäßen Anordnung ist es, dass durch die geringere Anzahl und / oder geringere Größe der Lunker in der Sintermetallschicht die elektrischen Eigenschaften verbessert, speziell der ohmsche Widerstand verringert, wird und zudem die Dauerhaltbarkeit der Verbindung verbessert wird. Gerade auch in Verbindung mit der der Beaufschlagung durch Ultraschall kann zusätzlich der notwendige Druck zur Ausbildung dieser Verbindung gegenüber dem Stand der Technik um mehr als 10% verringert werden. Jegliche Verringerung des notwendigen und aufzubringenden Druckes erhöht unmittelbar die Ausbeute des Verfahrens, da hierdurch die Bruchrate verringert werden kann.

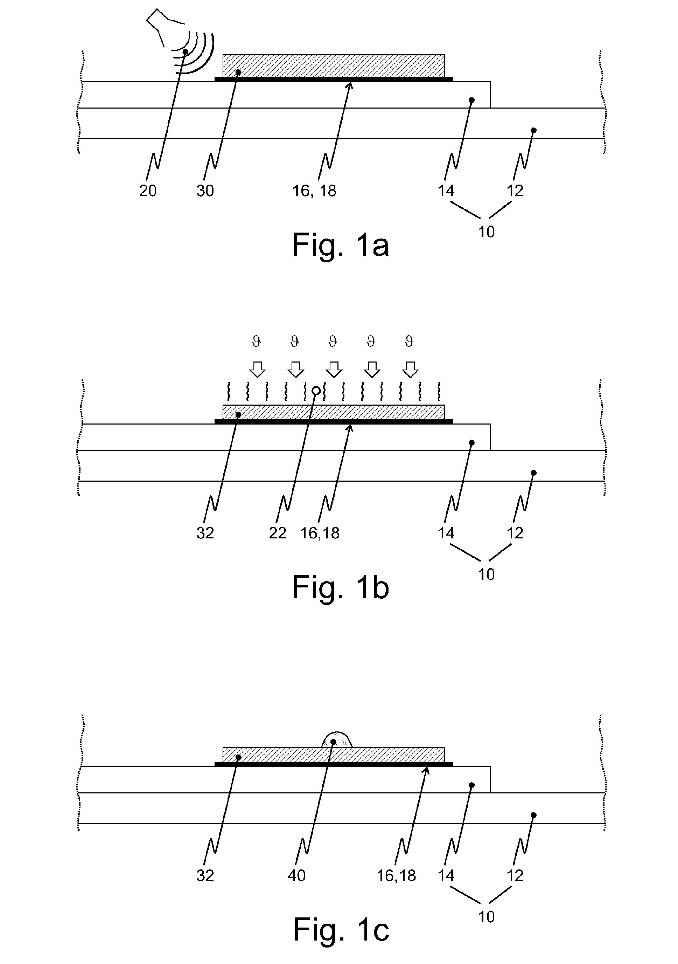

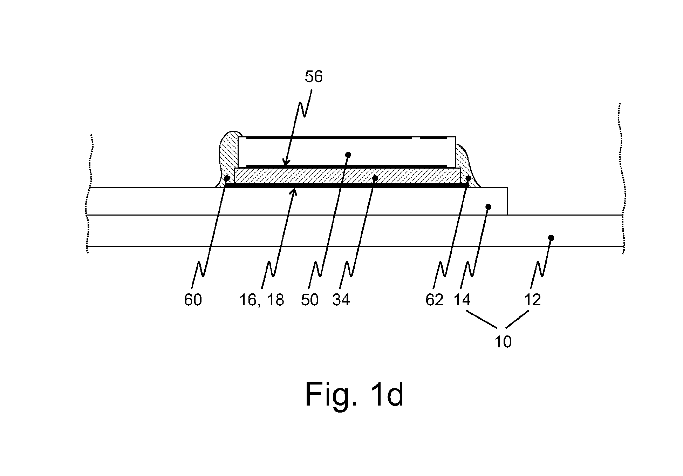

Die erfinderische Lösung wird an Hand des Ausführungsbeispiels gemäß Fig. 1 weiter erläutert, wobei Fig. 1 verschiedene Schritte des erfindungsgemäßen Herstellungsverfahrens zeigt.

Fig. 1a zeigt als ersten Verbindungspartner einen Ausschnitt eines typischen Substrats (10), wie es im Bereich der Leistungselektronik Anwendung findet. Dieses Substrat (10) besteht aus einem Isolierstoffkörper (12), vorzugsweise eine Industriekeramik wie beispielhaft Aluminiumnitrit und auf mindestens einer der Hauptflächen dieses Isolierstoffkörpers (12) einer Mehrzahl von metallischen Leiterbahnen (14) wovon eine dargestellt ist. Diese Leiterbahnen (14) sind vorzugsweise aus Kupfer ausgebildet und bilden gegeneinander elektrisch isoliert die Schaltstrukturen des Substrats (10) aus.

Die Kontaktfläche des Substrats mit der der zweite Verbindungspartner in elektrisch leitenden Kontakt gebracht werden soll, weist eine, einer Niedertemperatur-Drucksinterverbindung zugängliche Oberfläche auf. Hierzu ist es bevorzugt, wenn die Kontaktfläche (16) eine Edelmetalloberfläche (18) aufweist. Ebenfalls dargestellt ist eine auf dieser Kontaktfläche (16) angeordnete Sinterpaste (30), die ihrerseits aus Silberpartikeln und einem Lösungsmittel besteht. Im Vorfeld des Aufbringens dieser Sinterpaste (30) wurde begonnen die Oberfläche mit Ultraschall (20) zu beaufschlagen. Diese Beaufschlagung hielt auch während des Aufbringens der Sinterpaste (30) an. Durch diese Maßnahme werden Verunreinigungen, die die spätere Ausbildung der Niedertemperatur-Drucksinterverbindung beeinträchtigen könnten entfernt.

Fig. 1b zeigt schematisch als nachfolgenden Verfahrensschritt das temperaturinduzierte Austreiben des Lösungsmittels aus der Sinterpaste. Die Temperatureinwirkung (22) kann hierzu beliebig ausgebildet sein, beispielhaft kann sie neben der direkten Einwirkung auf die Sinterpaste (30) auch über eine Erwärmung des Substrats (10) ausgebildet werden. Der wesentliche Vorteil des Austreibens des Lösungsmittels bereits zu diesem Zeitpunkt liegt darin, dass bei eine späteren Austreiben nach Anordnung des zweiten Verbindungspartners dies nicht mehr derart umfänglich erzielt werden kann. Zurückbleibendes Lösungsmittel führt zu Lunkern, die bei dem erfindungsgemäßen Verfahren wesentlich kleiner ausgebildet sind.

Nach diesem Verfahrenschritt liegen von der Sinterpaste (30, gemäß Fig. 1a) fast nur noch die Edelmetallpartikel vor, was im Folgenden als Sinterschicht (32) bezeichnet werden soll. Im Gegensatz zu den bei Sinterpasten durch den Lösungsmittelanteil gegebenen adhäsiven Effekt auf einen auf der Oberfläche angeordneten zweiten Verbindungspartner, weist die Sinterschicht (32) keine oder nur sehr geringe adhäsive Kräfte ihrer freien Oberfläche auf zweite Verbindungspartner auf.

Um dennoch eine Fixierung des zweiten Verbindungspartners zu erreichen wird, dargestellt in Fig. 1c, eine Flüssigkeit (40) auf die freie Oberfläche der Sinterschicht (32) appliziert. Beim Anordnen des zweiten Verbindungspartners bildet diese Flüssigkeit (40) eine sehr dünne Schicht aus, die adhäsive Kräfte zwischen der Sinterschicht (32) und dem zweiten Verbindungsparten, hier einem Leistungshalbleiterbauelement (50, vgl. Fig. 1d), ausbildet. Somit wird dieses Leistungshalbleiterbauelement (50) in seiner Position auf der Sinterschicht (32) fixiert, wodurch das weitere Handling während des Verfahrens wesentlich vereinfacht wird. Als besonders geeignete Flüssigkeit haben sich hier kurzkettige, mehrwertige Alkohole, wie Glycerin, auf Grund ihrer physikalischen Eigenschaften, wie geringem Dampfdruck bei gleichzeitig geringer Siedetemperatur, erwiesen.

Alternativ aber besonders bevorzugt zusätzlich zur Fixierung, wie unter Fig. 1c beschrieben, kann der zweiter Verbindungspartner mit seiner Kontaktfläche (56), das Leistungshalbleiterbauelement (50), auch mittels eines weiteren Adhäsionsmittels (60) in seinem und dem Randbereich der Sinterschicht (32) sowie mit Kontakt zum ersten Verbindungspartner, dem Substrat (10), zu diesem fixiert werden.

Hierbei kann es ausreichend sein diese Fixierung an zwei oder drei Stellen in dem beschriebenen Randbereich vorzusehen. Falls allerdings eine Fixierung durch die oben beschriebene Flüssigkeit (40) nicht gegeben ist, ist es vorteilhaft dieses Adhäsionsmittel rings um den gesamten Randbereich vorzusehen.

Bei beiden Ausführungen sind grundsätzlich zwei Varianten gleichwirkend und auch gleichermaßen bevorzugt. Fig. 1d zeigt links eine Anordnung des Adhäsionsmittels (60) das bis auf die Oberseite des zweiten Verbindungspartner, des Leistungshalbleiterbauelements (50), reicht, während rechts das Adhäsionsmittel (62) ausschließlich seitlich am Leistungshalbleiterbauelement (50) und ansonsten gleich dem auf der rechten Seite angeordnet ist.

## Patentansprüche

1. Verfahren zur Herstellung einer Anordnung mit einem ersten (10) und einem zweiten Verbindungspartner (50), die mittels einer Niedertemperatur-Drucksinterverbindung miteinander stoffschlüssig verbunden sind, wobei die Verbindungspartner (10, 50) jeweils eine mit dem jeweils anderen Verbindungspartner zu verbindenden Kontaktfläche (16, 56) aufweisen, wobei zwischen diesen Kontaktflächen (16, 56) eine Sintermetallschicht (34) angeordnet ist,
**gekennzeichnet durch** diese aufeinander folgenden Schritte, wobei die Schritte d) und f) nacheinander oder alternativ ausgeführt werden können:
a) Bereitstellen eines ersten Verbindungspartners (10) mit einer ersten Kontaktfläche (16);
b) Aufbringen einer Schicht aus einer Sinterpaste (40), bestehend aus Sintermetallpartikeln und einem Lösungsmittel, auf die erste Kontaktfläche (16);
c) Temperaturbeaufschlagung (22) der Sinterpaste (30) und Austreiben des Lösungsmittels unter Bildung der Sinterschicht (32);
d) Aufbringen einer Flüssigkeit (40) auf der Sinterschicht (32);
e) Anordnen des zweiten Verbindungspartners (50) derart, dass dessen zweite Kontaktfläche (56) auf der Sinterschicht (32) zu liegen kommt;
f) Anordnen eines Adhäsionsmittels (60, 62) im Randbereich der Sinterschicht (32) und des zweiten Verbindungspartners (50) mit Kontakt zum ersten Verbindungspartner (10) zur Fixierung der Verbindungspartner (10, 50) zueinander;
g) Weitere Beaufschlagung der Anordnung mit Temperatur und Druck zur Ausbildung der stoffschlüssigen Niedertemperatur-Drucksinterverbindung zwischen den Verbindungspartnern (10, 50), wobei die Sinterschicht (32) zur homogenen Sintermetallschicht (34) umgewandelt wird.

2. Verfahren nach Anspruch 1, wobei
die Flüssigkeit (40) als eine polare Flüssigkeit, vorzugsweise kurzkettige, mehrwertige Alkohole wie Glycerin, ausgebildet ist.

3. Verfahren nach Anspruch 1, wobei
das Adhäsionsmittel (60, 62) als ein, vorzugsweise thermisch vernetzendes, Silikon ausgebildet ist.

4. Verfahren nach Anspruch 1, wobei
das Adhäsionsmittel (60, 62) an mindestens zwei Stellen im Randbereich oder umlaufend aufgebracht wird.

5. Verfahren nach Anspruch 1, wobei
unmittelbar vor Ausführung des Schrittes b) die erste Kontaktfläche (16) und der diese direkt umgebende Bereich mit Ultraschall (20) beaufschlagt wird.

6. Verfahren nach Anspruch 1, wobei
unmittelbar vor und während der Ausführung des Schrittes b) die erste Kontaktfläche (16) und der diese direkt umgebende Bereich mit Ultraschall (20) beaufschlagt wird.

7. Anordnung, ausgebildet nach einem Verfahren gemäß einem der vorhergehenden Ansprüche, mit einem ersten (10) und einem zweiten Verbindungspartner (50), die mittels einer Niedertemperatur-Drucksinterverbindung miteinander stoffschlüssig verbunden sind, wobei die Verbindungspartner (10, 50) jeweils eine mit dem jeweils anderen Verbindungspartner zu verbindenden Kontaktfläche (16, 56) aufweisen, wobei zwischen diesen Kontaktflächen (16, 56) ein Sintermetall (34) angeordnet ist und als homogene Schicht ausgebildet ist und ausschließlich Lunker mit einem Durchmesser von maximal 10 µm aufweist.

8. Anordnung nach Anspruch 7, wobei
im Randbereich der Sintermetallschicht (34) ein Adhäsionsmittel (60, 62) vorgesehen ist, das mit beiden Verbindungspartner (10, 50) in Kontakt steht.
